# EUROPEAN PATENT APPLICATION

(11) **EP 4 752 937 A1**
(43) Date of publication of application: **03.06.2026**
(21) Application number: 24845509.9
(22) Date of filing: 17.07.2024
(51) Int. Cl.: H01L 23/427, F28D 15/02, H05K 7/20

(54) **ELECTRONIC DEVICE**

(30) Priority: 27.07.2023 JP 2023122668
(71) Applicant: Sony Interactive Entertainment Inc., Tokyo 108-0075 (JP)
(72) Inventor: TANIMOTO, Naoki, Tokyo 108-0075 (JP); SASAKI, Chiyoshi, Tokyo 108-0075 (JP); TSUCHIDA, Shinya, Tokyo 108-0075 (JP)
(74) Representative: Fish & Richardson P.C.
(86) International application number: PCT/JP2024/025696
(87) International publication number: WO 2025/023130

(57) **Abstract**

An electronic device is provided that can improve cooling capacity of a heating element built into an electronic device disposed in a plurality of postures. A heat pipe (50) includes a heat dissipation portion (51) connected to a heat sink (61, 62) and an outer surface (53) in contact with a heat transfer member (70), and includes a pipe lower portion (52) positioned below the heat transfer member (51) and extending in a direction intersecting the vertical direction when a device body (11) is in a vertical posture. The pipe lower portion (52) includes an extension portion (55) extending outside an outer edge of the heat transfer member (70).

## Description

### TECHNICAL FIELD

The present disclosure relates to an electronic device.

### BACKGROUND TECHNOLOGY

An electronic device is sometimes used in a state of being disposed in a plurality of postures. For example, an electronic device described in Patent Document 1 below can be used in both a vertical posture and a horizontal posture. Furthermore, a heat dissipation device including a heat pipe and a heat sink is used to cool a heating element such as an IC chip built into the electronic device.

### CITATION LIST

### PATENT DOCUMENTS

Patent Document 1: JP 2021-158287 A

### SUMMARY OF INVENTION

### PROBLEM TO BE SOLVED BY INVENTION

In recent years, there has been a demand for structures with higher cooling performance, even for an electronic device disposed in a plurality of postures.

An object of the present disclosure is to provide an electronic device and a heat dissipation device that can improve cooling capacity of a heating element built into an electronic device disposed in a plurality of postures.

### MEANS TO SOLVE THE PROBLEM

An electronic device according to the present disclosure may include: a board on which a heating element is mounted; a housing that houses the board; a heat pipe housed in the housing and extending along the board; a heat sink housed in the housing and disposed above the heating element when the housing is in a first posture; and a heat transfer member positioned between the heating element and the heat pipe and in contact with both the heating element and the heat pipe. The heat pipe may include a heat dissipation portion connected to the heat sink, and a pipe lower portion including an outer surface in contact with the heat transfer member, and positioned below the heat dissipation portion when the housing is in the first posture, and extending in a direction intersecting the vertical direction. The pipe lower portion may include a tapered portion that includes a tip of the heat pipe and gradually tapers toward the tip, and an extension portion positioned outside an outer edge of the heat transfer member and extending to the tapered portion. Moreover, a space in which an outer surface of the extension portion is exposed may be secured on a side opposite to the heat transfer member with the pipe lower portion therebetween. Accordingly, it is possible to improve the cooling capacity of the heating element built into the electronic device disposed in a plurality of postures.

Furthermore, an electronic device according to the present disclosure may include: a board on which a heating element is mounted; a housing that houses the board; a heat pipe housed in the housing and extending along the board; a heat sink housed in the housing and disposed above the heating element when the housing is in a first posture; and a heat transfer member positioned between the heating element and the heat pipe and in contact with both the heating element and the heat pipe. The heat pipe may include a heat dissipation portion connected to the heat sink, and a pipe lower portion including an outer surface in contact with the heat transfer member, positioned below the heat dissipation portion when the housing is in the first posture, and extending in a direction intersecting the vertical direction. The pipe lower portion may include a heat receiving portion including an outer surface in contact with the heat transfer member and positioned inside an outer edge of the heat transfer member, and an extension portion positioned between the heat receiving portion and the heat dissipation portion and positioned below the heat receiving portion when the housing is in the first posture. Accordingly, it is possible to improve the cooling capacity of the heating element built into the electronic device disposed in the plurality of postures.

### BRIEF DESCRIPTION OF THE DRAWINGS

[FIG. 1A] FIG. 1A is a perspective view illustrating an example of an electronic device in a vertical posture.
[FIG. 1B] FIG. 1B is a perspective view illustrating an example of an electronic device in a horizontal posture.
[FIG. 2] FIG. 2 is an exploded perspective view illustrating some of components of a device body.
[FIG. 3A] FIG. 3A is a plan view of a heat dissipation device.
[FIG. 3B] FIG. 3B is a rear view of a heat dissipation device.
[FIG. 4] FIG. 4 is a cross-sectional view of a circuit board, a heat dissipation device, and a power supply device.
[FIG. 5A] FIG. 5A is an enlarged view of a heat pipe and heat transfer member in the cross-sectional view of FIG. 4.
[FIG. 5B] FIG. 5B is a cross-sectional view of a heat pipe taken along line VB-VB in FIG. 3B.
[FIG. 6] FIG. 6 is a cross-sectional view of a heat pipe incorporated into an electronic device according to another embodiment.
[FIG. 7] FIG. 7 is a plan view illustrating a portion of a heat dissipation device incorporated into an electronic device according to another embodiment.

### DESCRIPTION OF THE EMBODIMENTS

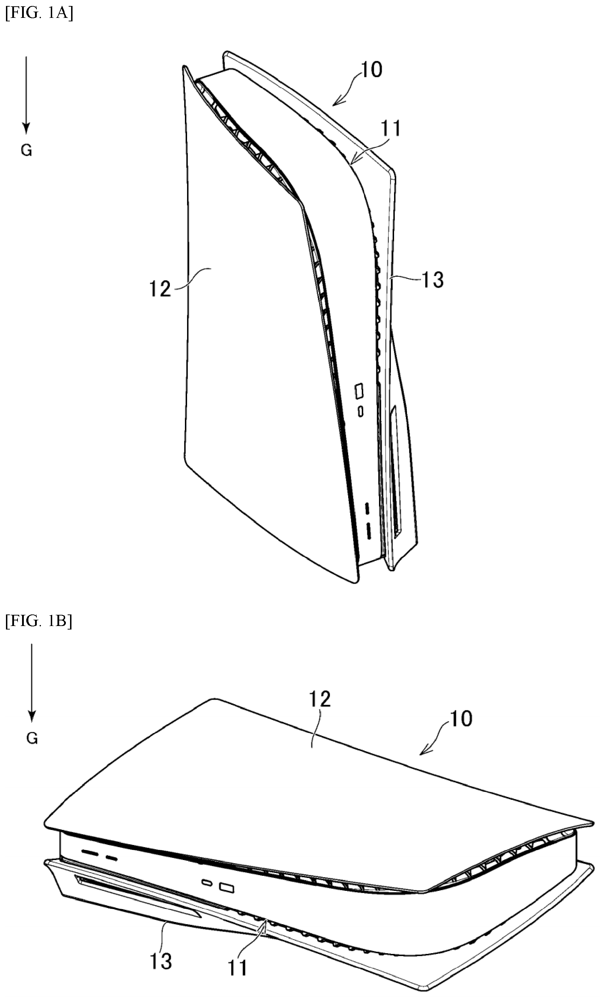

Below, an electronic device 10, which is an example of an electronic device proposed in the present disclosure, will be described with reference to the drawings. FIG. 1A is a perspective view illustrating the electronic device 10 in a vertical posture (first posture). FIG. 1B is a perspective view illustrating the electronic device 10 in a horizontal posture (second posture). In the following description, an arrow G in each drawing indicates the direction in which gravity acts, and is referred to as a "gravity direction G".

### [1. Overview of Electronic Device]

The electronic device 10 may be a computer, such as a game device, personal computer, or server computer. As illustrated in FIGS. 1A and 1B, the electronic device 10 may have a device body 11 and first and second covers 12 and 13 that cover device body 11. As illustrated in FIGS. 1A and 1B, first and second covers 12 and 13 may be sized to cover the entire device body 11, or may be sized to cover only a portion of device body 11.

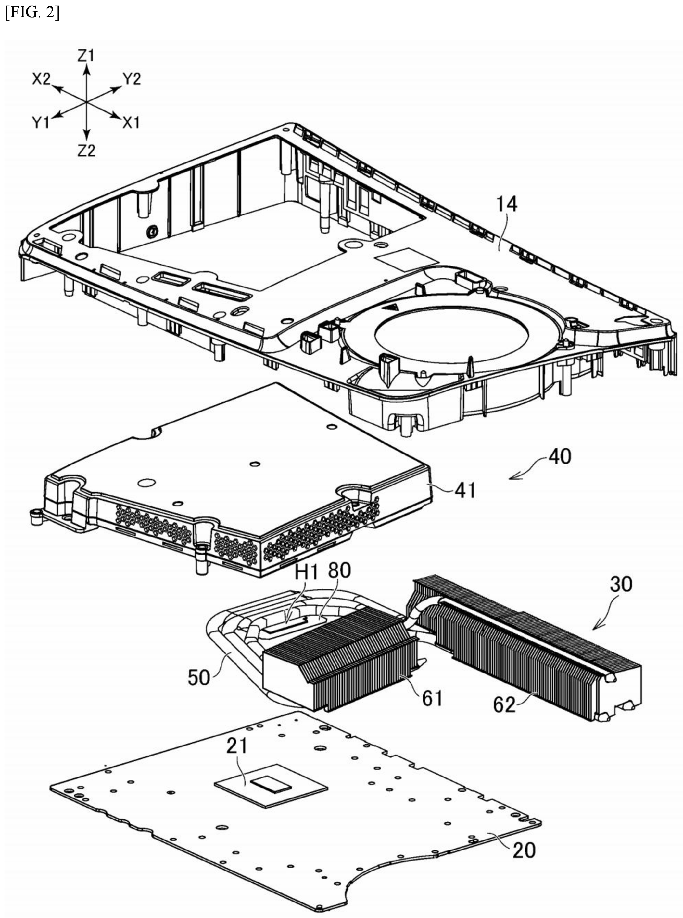

FIG. 2 is an exploded perspective view illustrating some of the components of the device body 11. In the following description, the X1 and X2 directions of the X axis illustrated in FIG. 2 or the like are defined as right and left directions, respectively. Furthermore, the Y1 and Y2 directions of the Y axis perpendicular to the X axis are defined as front and rear directions, respectively. Furthermore, the Z1 and Z2 directions of the Z axis perpendicular to the X and Y axes are defined as up and down directions, respectively. However, these directions are specified to explain the shapes and relative positions of the elements (components, members, and portions) of electronic device 10, and do not limit the posture of electronic device 10 relative to an installation surface such as a desk or floor.

The device body 11 may be a box-shaped housing. The device body 11 may have a first case 14 (illustrated in FIG. 2) that forms the outer surface of the housing, and a second case (not illustrated) that also forms a portion of the outer surface. Also, as illustrated in FIG. 2, the device body 11 may have a circuit board 20, a heat dissipation device 30, and a power supply device 40. The circuit board 20, the heat dissipation device 30, and the power supply device 40 may be housed inside the box-shaped housing formed by first case 14 and the second case.

The electronic device 10 may be disposed relative to an installation surface such as a desk or floor in either a vertical posture (first posture) as illustrated in FIG. 1A or a horizontal posture (second posture) as illustrated in FIG. 1B. The vertical posture refers to, for example, a posture in which the circuit board 20 housed inside the device body 11 stands upright relative to the installation surface. The horizontal posture refers to, for example, a posture in which the circuit board 20 housed inside the device body 11 is disposed along the installation surface. When the electronic device 10 is in the vertical posture illustrated in FIG. 1A, the circuit board 20 may be disposed along the gravity direction G. When the electronic device 10 is in the vertical posture illustrated in FIG. 1A, the direction of the X axis illustrated in FIG. 2 or the like may coincide with the gravity direction G. For this reason, the X1 direction and X2 direction illustrated in FIG. 2 and other drawings may also be referred to as the up direction and down direction.

As illustrated in FIG. 2, an electronic component that serves as the heating element may be mounted on the circuit board 20. For example, as the heating element, an IC chip 21 may be mounted on the circuit board 20. The IC chip 21 may be a flat semiconductor such as silicon, known as a die. The IC chip 21 may be a chip such as an SoC that integrates a Central Processing Unit (CPU), Graphics Processing Unit (GPU), and I/O functions. The IC chip 21 may also include memory functions such as a Read Only Memory (ROM) and Random Access Memory (RAM).

The heat dissipation device 30 is used to cool the IC chip 21, which is a heating element, and may be in contact with the IC chip 21. As illustrated in FIG. 2, the heat dissipation device 30 may be positioned above the IC chip 21 (in the direction indicated by Z1 in FIG. 2).

The circuit board 20 may be housed inside a circuit board shield (not illustrated) made of a conductive material such as iron or aluminum. An opening that exposes the IC chip 21 may be formed in the circuit board shield, and the heat dissipation device 30 may be connected to the IC chip 21 inside this opening. In the example illustrated in FIG. 2, the circuit board shield has a shield plate 80 with an opening H1 formed in a portion of the circuit board shield, and the heat dissipation device 30 may be in contact with the IC chip 21 inside this opening H1.

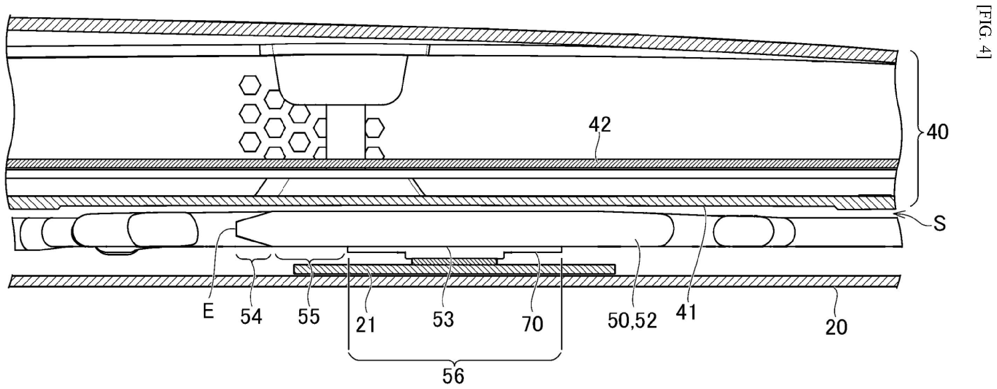

The power supply device 40 may use current supplied from an external power source to supply drive power to various components included in the device body 11, such as the IC chip 21. The power supply device 40 may have a case 41. A circuit board 42 (refer to FIG. 4) including a transformer, rectifier circuit, or the like may be housed inside the case 41. As illustrated in FIG. 2, the power supply device 40 may be positioned above the IC chip 21 and a plurality of heat pipes 50 (described later) (in the direction indicated by Z1 in FIG. 2).

### [2. Overview of Heat Dissipation Device]

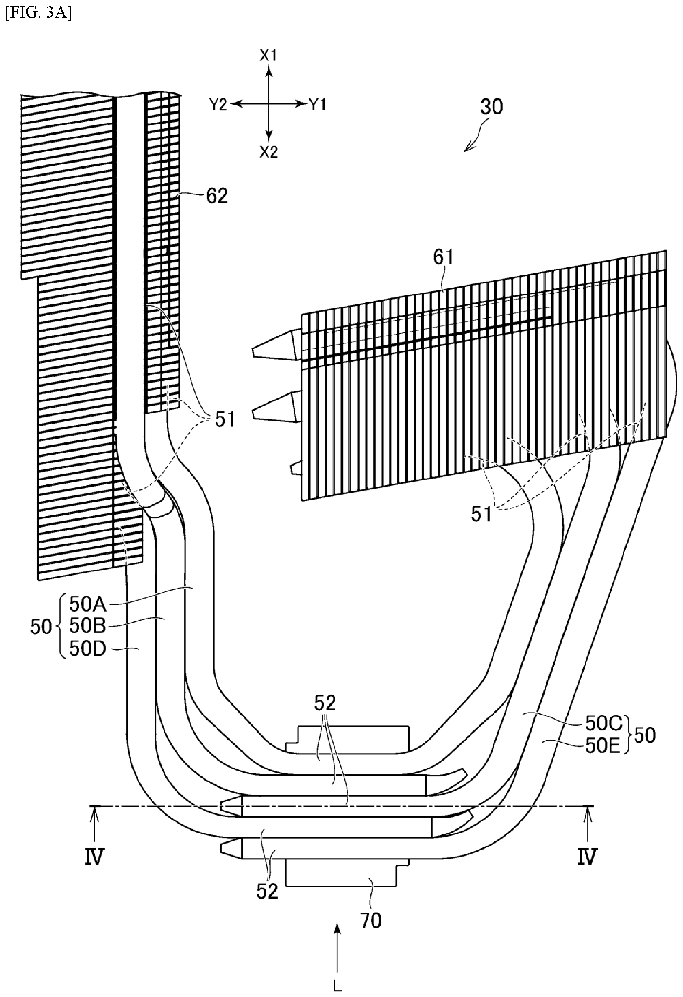

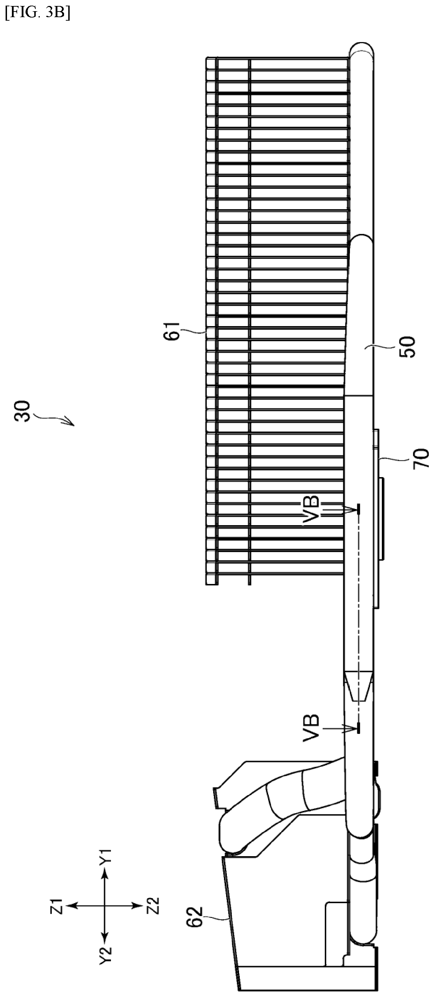

FIG. 3A is a plan view of the heat dissipation device 30. FIG. 3B is a side view of the heat dissipation device 30 and a view when the heat dissipation device 30 is viewed in the direction of an arrow L in FIG. 3A. FIG. 4 is a cross-sectional view of the circuit board 20, the heat dissipation device 30, and the power supply device 40. FIG. 4 is a cross-sectional view of the electronic device 10 incorporating the heat dissipation device 30 illustrated in FIG. 3A, and illustrates a cross-section taken along a cutting plane including line IV-IV in FIG. 3A.

As illustrated in FIG. 3A, the heat dissipation device 30 may include multiple rod-shaped heat pipes 50 (50A to 50E), heat sinks 61 and 62, and a heat transfer member 70. These members may be made of metals with high thermal conductivity, such as aluminum or copper, or may be made of iron.

The plurality of heat pipes 50 and the heat transfer member 70 may be used to transfer heat from the IC chip 21, which is the heating element, to the heat sinks 61 and 62. As illustrated in FIG. 4, the heat transfer member 70 may be positioned between the IC chip 21 and the heat pipes 50 and may be in contact with both the IC chip 21 and the heat pipes 50. Moreover, the heat pipes 50 may be connected to one or both of the heat sinks 61 and 62. Accordingly, the heat of the IC chip 21 can be transferred to the heat sinks 61 and 62 via the heat transfer member 70 and the heat pipes 50.

The heat sinks 61 and 62 may be thermally connected to the IC chip 21, which is the heating element, via the heat transfer member 70 and the heat pipe 50. The heat sinks 61 and 62 may include a plurality of heat dissipation fins. Accordingly, the heat of the IC chip 21, transferred via the heat transfer member 70 and the heat pipe 50, can be efficiently dissipated to the outside of the electronic device 10, or the like. As illustrated in FIG. 3A, when the device body 11 (housing) is in the vertical posture (first posture), the heat sinks 61 and 62 may be positioned above (in the direction indicated by X1 in FIG. 3A) the IC chip 21 (refer to FIG. 4) which is a heating element, and the heat transfer member 70 in contact with the IC chip.

### [3. Heat Pipe Structure]

As illustrated in FIG. 2, each of the plurality of heat pipes 50 (50A to 50E) may extend along the circuit board 20. As illustrated in FIG. 3A, each heat pipe 50 may have a heat dissipation portion 51 connected to the heat sink 61 or 62. The outer surface of the heat dissipation portion 51 may be in contact with the fins of the heat sink 61 or 62. The heat dissipation portion 51 may be located between the fins positioned at one end of the heat sink 61 (or the heat sink 62) and the fins positioned at the other end.

Each heat pipe 50 may have a pipe lower portion 52. When the device body 11, which is the housing, is in the vertical posture (first posture), the pipe lower portion 52 may be located below the heat dissipation portion 51 (in the direction indicated by X2 in FIG. 3A) and may extend in a direction intersecting the vertical direction (direction indicated by the X axis in FIG. 3A). As illustrated in FIG. 4, the pipe lower portion 52 of each heat pipe 50 may have an outer surface 53 in contact with the heat transfer member 70.

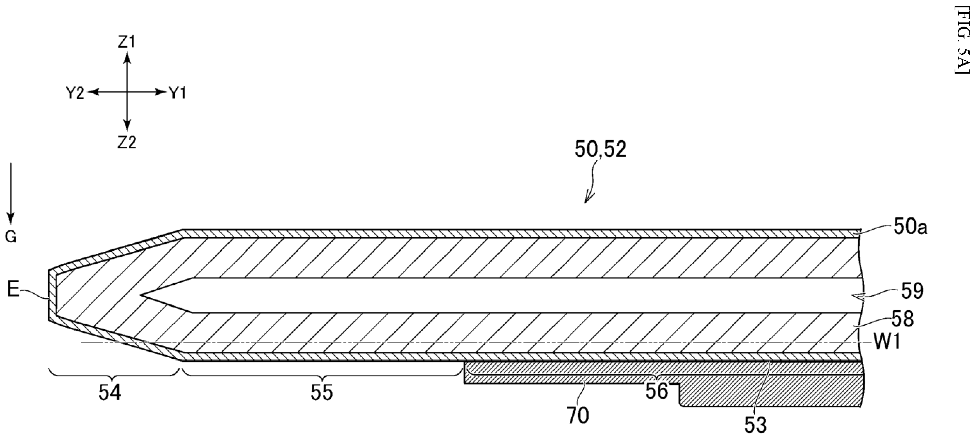

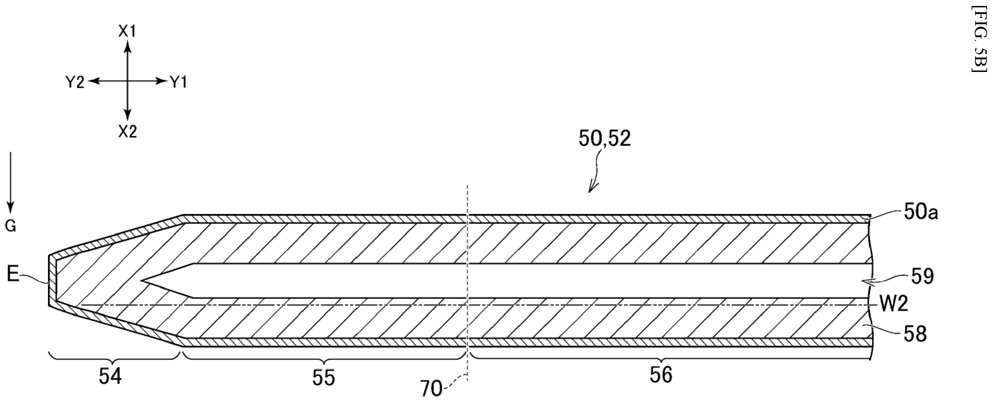

FIG. 5A is an enlarged view of the pipe lower portion 52 of the heat pipe 50 (heat pipe 50C illustrated in FIG. 3A) and the heat transfer member 70 in the cross-sectional view of FIG. 4. FIG. 5B is a cross-sectional view of the pipe lower portion 52 of the heat pipe 50 (heat pipe 50C illustrated in FIG. 3A) taken along line VB-VB in FIG. 3B. FIG. 5A illustrates the device body 11 in the horizontal posture. FIG. 5B illustrates the device body 11 in the vertical posture.

As illustrated in FIGS. 4, 5A, and 5B, the pipe lower portion 52 of each heat pipe 50 may include a tapered portion 54 that includes a tip E of the heat pipe 50 and gradually tapers toward the tip E. The pipe lower portion 52 of each heat pipe 50 may have an extension portion 55 positioned outside the outer edge of the heat transfer member 70 and extending to the tapered portion 54. The cross-sectional area (the area of a cross section perpendicular to the extension portion 55) of the extension portion 55 may be substantially uniform.

Furthermore, as illustrated in FIGS. 4, 5A, and 5B, the pipe lower portion 52 of each heat pipe 50 may include an outer surface 53 in contact with the heat transfer member 70 and have a heat receiving portion 56 positioned inside the outer edge of the heat transfer member 70. When the device body 11 is in the vertical posture (first posture), the extension portion 55 of each heat pipe 50 may be positioned at the same position as the heat receiving portion 56 in the vertical direction (the direction illustrated on the X axis in FIGS. 3A and 5B) or below the heat receiving portion 56. In the example illustrated in FIGS. 3A and 5B, the extension portion 55 is located at the same position as the heat receiving portion 56 in the vertical direction.

Furthermore, when the device body 11 is in the vertical posture, the heat receiving portion 56 of each heat pipe 50 may extend in the direction (a first direction intersecting the vertical direction indicated by the X axis in FIG. 5B) indicated by the Y axis in each drawing. Here, the extension portion 55 of each heat pipe 50 may include a portion extending from the heat receiving portion 56 in the front-rear direction (the right-left direction in FIG. 5B), or in both the front-rear direction and a downward diagonal direction. In the example illustrated in FIG. 5B, the entire extension portion 55 extends forward (in the Y2 direction, or to the left direction in FIG. 5B) from the heat receiving portion 56.

Furthermore, as illustrated in FIG. 4, a space S in which the outer surface of the extension portion 55 of the heat pipe 50 is exposed may be secured on the side opposite to the heat transfer member 70 with the pipe lower portion 52 of each heat pipe 50 therebetween. In the examples illustrated in FIGS. 3A and 4, the extension portion 55 is not in contact with the heat sinks 61 and 62. In the example illustrated in FIG. 4, the power supply device 40 is disposed inside the device body 11, which is the housing, and the space S is secured between the power supply device 40 and the extension portion 55. In the example illustrated in FIG. 4, the extension portion 55 is not in contact with the power supply device 40. The extension portion 55 may be disposed away from all members and components housed in the device body 11 and may not be in contact with these members and components. Accordingly, it is possible to prevent the heat pipe 50 from being pressed by components or members, such as the power supply device 40, from the side opposite to the circuit board 20, thereby preventing external force from being applied to the circuit board 20.

As illustrated in FIGS. 5A and 5B, each heat pipe 50 may have a sintered body layer 58 formed by sintering a powder such as a metal laminated on the inner wall surface of a tube 50a, including the outer surface 53. The sintered body layer 58 may be formed in a cylindrical shape inside the tube 50a, and a cavity 59 may be formed inside the sintered body layer 58. A working fluid may be sealed inside the tube 50a. The working fluid may be selected appropriately depending on the material of the tube 50a, and may be water, for example.

The sintered body layer 58 may contain numerous voids corresponding to the shape and particle size of the sintered metal or other powder. The working fluid may be absorbed into the voids in the sintered body layer 58 and may move through the sintered body layer 58 due to the capillary force of the sintered body layer 58. The working fluid present in the sintered body layer 58 may be heated and vaporized by receiving heat from the heat transfer member 70. In this way, the working fluid is vaporized in the heat receiving portion 56 in contact with the heat transfer member 70 of each heat pipe 50, and thus, heat is absorbed from the heat transfer member 70 and the IC chip 21 in contact with the heat transfer member 70 can be cooled.

The vaporized working fluid may also be able to move within the cavity 59. The vapor of the working fluid present in cavity 59 may condense and liquefy due to the heat dissipation effect of the heat sink 61 and/or heat sink 62. This liquefied working fluid may then move through the sintered body layer 58, receive heat from the heat transfer member 70 in the heat receiving portion 56, be heated, and be vaporized. By circulating the working fluid inside each heat pipe 50 in this manner, heat from the heat transfer member 70 can be efficiently absorbed, and the IC chip 21 in contact with the heat transfer member 70 can be cooled.

When the device body 11 is in the horizontal posture, as illustrated in FIG. 2, since each heat pipe 50 extends along the circuit board 20, the working fluid permeates a relatively wide area of the sintered body layer 58. That is, the working fluid spreads substantially uniformly along the entire length of each heat pipe 50. In contrast, when the device body 11 is in the vertical posture, as illustrated in FIG. 3A, since the pipe lower portion 52 of each heat pipe 50 is positioned below the heat dissipation portion 51 in contact with the heat sink 61 or the heat sink 62, the amount of working fluid that accumulates in the pipe lower portion 52 increases. Therefore, the water level (refer to W2 in FIG. 5B) of the working fluid in the pipe lower portion 52 when the device body 11 is in the vertical posture is higher than the water level (refer to W1 in FIG. 5A) of the working fluid in the pipe lower portion 52 when the device body 11 is in the horizontal posture.

In order to vaporize the working fluid in the heat receiving portion 56 of each heat pipe 50, it is preferable that the water level of the working fluid in the heat receiving portion 56 does not exceed the height of the sintered body layer 58 (that is, the water level of the working fluid does not reach the cavity 59). In order to lower the position of the water level of the working fluid in the pipe lower portion 52 when the device body 11 is in the vertical posture, as described above, the pipe lower portion 52 may be formed with the extension portion 55 extending from the heat receiving portion 56 in contact with the heat transfer member 70 to the tapered portion 54. By forming the extension portion 55 in this manner, it is possible to secure a capacity for the working fluid to accumulate in the sintered body layer 58 of the pipe lower portion 52 when the device body 11 is in the vertical posture, and it is possible to lower the position of the water level W2 of the working fluid (refer to FIG. 5B) in the heat receiving portion 56. Accordingly, it is possible to efficiently vaporize the working fluid inside each heat pipe 50 even when the device body 11 is in the vertical posture, and it is possible to efficiently cool the IC chip 21 which is the heating element mounted on the circuit board 20.

Furthermore, as illustrated in FIG. 4, the space S in which the outer surface (more specifically, the outer surface of the extension portion 55) of the pipe lower portion 52 is exposed may be secured on the side (more specifically, between the power supply device 40 and the extension portion 55 of the heat pipe 50) opposite to the heat transfer member 70 with the pipe lower portion 52 of each heat pipe 50 therebetween. As described above, by securing the space S between the heat pipe 50 and components or members such as the power supply device 40, it is possible to prevent the heat pipe 50 from being pushed from the side opposite to the circuit board 20, thereby preventing external force from being applied to the circuit board 20.

### [4. Modification]

Note that the present invention is not limited to the above-described embodiments.

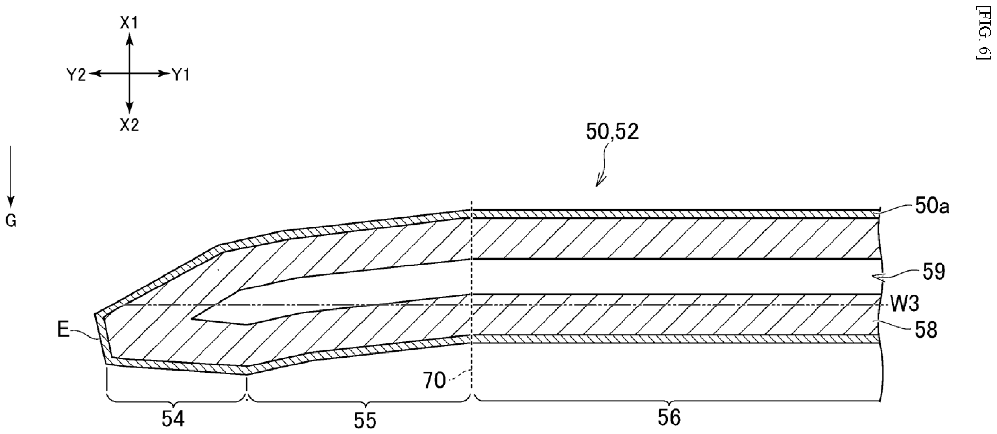

(1) FIG. 6 is a cross-sectional view of the pipe lower portion 52 of the heat pipe 50 incorporated in an electronic device according to another embodiment. FIG. 6 illustrates the device body 11 in the vertical posture (first posture). As illustrated in FIG. 6, when the device body 11 is in the vertical posture, the extension portion 55 of the heat pipe 50 may be positioned below the heat receiving portion 56 (in the direction indicated by X2 in FIG. 6) in the vertical direction (the direction indicated by the X axis in FIG. 6). Moreover, as illustrated in FIG. 6, when the device body 11 is in the vertical posture, the heat receiving portion 56 of the heat pipe 50 may extend in the front- rear direction (the first direction, the direction indicated by the Y axis in FIG. 6), and the extension portion 55 may include a portion extending in both the front-rear direction and the downward diagonal direction.

This arrangement also ensures that the sintered body layer 58 in the pipe lower portion 52 has sufficient capacity for the working fluid to accumulate when the device body 11 is in the vertical posture, and the water level W3 (refer to FIG. 6) of the working fluid in the heat receiving portion 56 can be lowered. Accordingly, it is possible to efficiently vaporize the working fluid inside the heat receiving portion 56 even when the device body 11 is in the vertical posture, thereby efficiently cooling the IC chip 21.

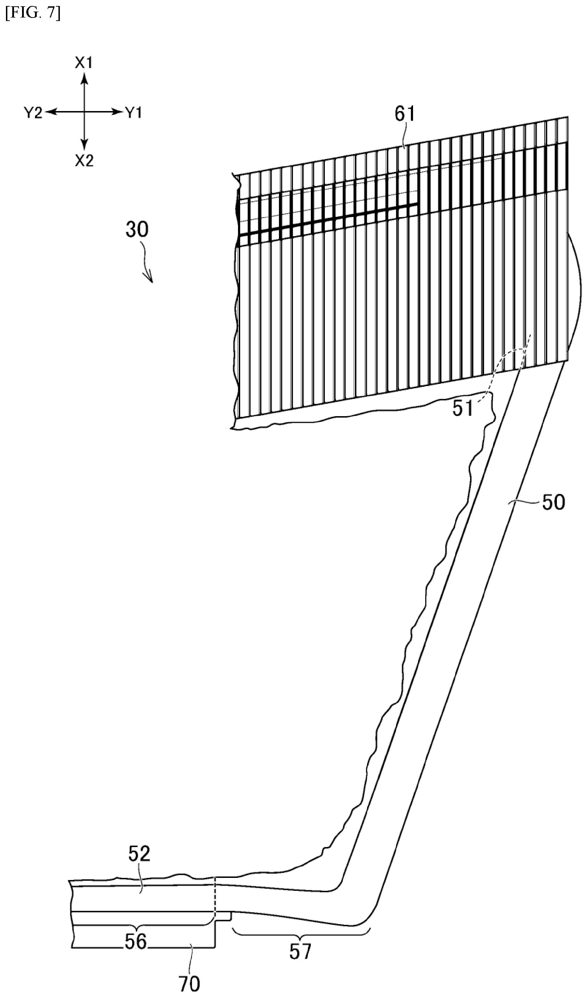

(2) FIG. 7 is a plan view illustrating a portion of the heat dissipation device 30 built into an electronic device according to another embodiment. In the heat dissipation device 30 illustrated in FIG. 7, the heat pipe 50 has an extension portion 57 located between the heat receiving portion 56 and the heat dissipation portion 51. As illustrated in FIG. 7, when the device body 11 is in the vertical posture (first posture), the extension portion 57 may be positioned below the heat receiving portion 56 (in the direction indicated by X2 in FIG. 7). That is, the bottom surface (the surface facing the X2 direction) of the extension portion 57 may be lower than the bottom surface of the heat receiving portion 56. As illustrated in FIG. 7, when the device body 11 is in the vertical posture, the heat receiving portion 56 may extend in the front-rear direction (first direction, the direction indicated by the Y axis in FIG. 7). Furthermore, the extension portion 57 may include a portion extending diagonally downward from the heat receiving portion 56 in the front-rear direction.

This configuration also ensures that the sintered body layer 58 within the extension portion 57 has sufficient capacity for the working fluid to accumulate when the device body 11 is in the vertical posture. Accordingly, it is possible to lower the position of the water level of the working fluid in the heat receiving portion 56, allowing the working fluid inside the heat receiving portion 56 to be efficiently vaporized. As a result, the IC chip 21 can be efficiently cooled.

### [5. Summary]

(1) As described above, the electronic device described in the present disclosure may include a board on which a heating element is mounted, a housing that houses the board, a heat pipe housed in the housing and extending along the board, a heat sink housed in the housing and disposed above the heating element when the housing is in a first posture, and a heat transfer member positioned between the heating element and the heat pipe and in contact with both the heating element and the heat pipe. The heat pipe may include a heat dissipation portion connected to the heat sink, and a pipe lower portion including an outer surface in contact with the heat transfer member, and positioned below the heat dissipation portion when the housing is in the first posture, and extending in a direction intersecting the vertical direction. The pipe lower portion may include a tapered portion that includes a tip of the heat pipe and gradually tapers toward the tip, and an extension portion positioned outside an outer edge of the heat transfer member and extending to the tapered portion. A space in which an outer surface of the extension portion is exposed may be secured on a side opposite to the heat transfer member with the pipe lower portion therebetween. Accordingly, it is possible to improve the cooling capacity of the heating element built into the electronic device disposed in a plurality of postures.
(4) Furthermore, an electronic device according to the present disclosure may include a board on which a heating element is mounted, a housing that houses the board, a heat pipe housed in the housing and extending along the board, a heat sink housed in the housing and disposed above the heating element when the housing is in a first posture, and a heat transfer member positioned between the heating element and the heat pipe and in contact with both the heating element and the heat pipe. The heat pipe may include a heat dissipation portion connected to the heat sink and a pipe lower portion including an outer surface in contact with the heat transfer member, positioned below the heat dissipation portion when the housing is in the first posture, and extending in a direction intersecting the vertical direction. The pipe lower portion may include a heat receiving portion including an outer surface in contact with the heat transfer member and positioned inside an outer edge of the heat transfer member, and an extension portion positioned between the heat receiving portion and the heat dissipation portion and positioned below the heat receiving portion when the housing is in the first posture. Accordingly, it is possible to improve the cooling capacity of the heating element built into the electronic device disposed in the plurality of postures.
(2) In the electronic device described in (1) or (4) above, the pipe lower portion may include an outer surface in contact with the heat transfer member and may include a heat receiving portion positioned inside the outer edge of the heat transfer member. When the housing is in the first posture, the extension portion may be positioned at the same position as the heat receiving portion in the vertical direction or below the heat receiving portion.
(3) In the electronic device described in (2) above, when the housing is in the first posture, the heat receiving portion may extend in a first direction intersecting the vertical direction, and the extension portion may include a portion extending from the heat receiving portion in the first direction or in both the first direction and a downward diagonal direction.
(5) In the electronic device described in any one of (2) to (4) above, when the housing is in a first posture, the heat receiving portion may extend in a first direction intersecting the vertical direction, and the extension portion may include a portion extending from the heat receiving portion in the first direction and a downward diagonal direction.

## Claims

1. An electronic device comprising:
a board on which a heating element is mounted;
a housing that houses the board;
a heat pipe housed in the housing and extending along the board;
a heat sink housed in the housing and disposed above the heating element when the housing is in a first posture; and
a heat transfer member positioned between the heating element and the heat pipe and in contact with both the heating element and the heat pipe,
wherein the heat pipe includes
a heat dissipation portion connected to the heat sink, and
a pipe lower portion including an outer surface in contact with the heat transfer member, and positioned below the heat dissipation portion when the housing is in the first posture, and extending in a direction intersecting the vertical direction,
the pipe lower portion includes
a tapered portion that includes a tip of the heat pipe and gradually tapers toward the tip, and
an extension portion positioned outside an outer edge of the heat transfer member and extending to the tapered portion, and
a space in which an outer surface of the extension portion is exposed is secured on a side opposite to the heat transfer member with the pipe lower portion therebetween.

2. The electronic device according to claim 1, wherein the pipe lower portion includes an outer surface in contact with the heat transfer member and includes a heat receiving portion positioned inside the outer edge of the heat transfer member, and
when the housing is in the first posture, the extension portion is positioned at the same position as the heat receiving portion in the vertical direction or below the heat receiving portion.

3. The electronic device according to claim 2, wherein when the housing is in the first posture, the heat receiving portion extends in a first direction intersecting the vertical direction, and the extension portion includes a portion extending from the heat receiving portion in the first direction or in both the first direction and a downward diagonal direction.

4. An electronic device comprising:
a board on which a heating element is mounted;
a housing that houses the board;
a heat pipe housed in the housing and extending along the board;
a heat sink housed in the housing and disposed above the heating element when the housing is in a first posture; and
a heat transfer member positioned between the heating element and the heat pipe and in contact with both the heating element and the heat pipe,
wherein the heat pipe includes
a heat dissipation portion connected to the heat sink, and
a pipe lower portion including an outer surface in contact with the heat transfer member, and positioned below the heat dissipation portion when the housing is in the first posture, and extending in a direction intersecting the vertical direction, and
the pipe lower portion includes
a heat receiving portion including an outer surface in contact with the heat transfer member and positioned inside an outer edge of the heat transfer member, and
an extension portion positioned between the heat receiving portion and the heat dissipation portion and positioned below the heat receiving portion when the housing is in the first posture.

5. The electronic device according to claim 4, wherein when the housing is in the first posture, the heat receiving portion extends in a first direction intersecting the vertical direction, and the extension portion includes a portion extending from the heat receiving portion in the first direction and a downward diagonal direction.
